# EUROPEAN PATENT APPLICATION

(11) **EP 0 776 945 A2**
(43) Date of publication of application: **04.06.1997**
(21) Application number: 96119222.6
(22) Date of filing: 29.11.1996
(51) Int. Cl.: C08L 83/06

(54) **Radiation-curable coating composition useful for protecting electronic circuitry and method of curing the same**

(30) Priority: 30.11.1995 JP 336112/95; 30.11.1995 JP 336113/95
(71) Applicant: Dow Corning Toray Silicone Company, Limited, Tokyo 103 (JP)
(72) Inventor: Mine, Katsutoshi, Dow Corning Toray Silicone Co, Ichihara-shi, Chiba Pref. (JP); Naito, Hiroshi, Dow Corning Toray Silicone Co, Ichihara-shi, Chiba Pref. (JP)
(74) Representative: Spott, Gottfried, Dr.

(57) **Abstract**

Novel, acryl-functional radiation-curable siloxane resins, having utility for coating and protecting electronic circuitry, are disclosed. The compositions may be cured utilizing a two step procedure wherein the coating composition if first irradiated with ultraviolet radiation and thereafter heated to a temperature between about 100°C and 300°C. The cured coating compositions of the invention exhibit high hardness and excellent adhesion to the type of organic resins used to support electrical circuitry, such as epoxy resins.

## Description

### BACKGROUND OF THE INVENTION

### 1. Field of the Invention.

The present invention relates generally to radiation-curable coating compositions and more particularly to such compositions that include acryl-functional organosiloxanes. The compositions of the invention are useful for protecting electronic circuitry and the cured coatings formed therefrom have high hardness and exhibit excellent adhesion to organic resins or the type used to mount electronic circuits.

### 2. Background of the Prior Art.

Radiation-curable organosiloxane compositions having acryl-functionality are known in the art. For example, Japanese Kokai Patent Application No. Sho 61[1986]-111330 discloses a composition consisting of an acryl functional silicone resin. Japanese Kokai Patent Application No. Sho 58[1983]-1756 discloses a composition consisting of a colloidal silica, a multifunctional acrylate monomer, and an acrylate silane hydrolysis product. Japanese Kokoku Patent No. Hei 6[1994]-29382 discloses a composition consisting of an acryl functional silicone resin and a multifunctional acrylate monomer.

The compositions of the prior art suffer from the drawback that the cured films formed therefrom have insufficient hardness. Furthermore, the cured films exhibit poor adhesion to the type of organic resins used in electronic circuitry, such as epoxy resins used as semiconductor-sealing resins. Thus, the use of the prior art coatings to protect electronic parts has been limited.

The coatings of the prior art also suffer from poor, or incomplete, curing. Oxygen inhibition of the curing mechanism can prevent any curing of thin films of the prior art compositions. If thick films are used, insufficient curing often results at the coating surface chat is in contact with air.

### SUMMARY OF THE INVENTION

The composition of the present invention overcomes the drawbacks of the prior art in that it provides a radiation-curable composition that when cured forms a film a hard film that exhibits excellent adhesion to semiconductor sealing resins of the type used in electronic circuitry. The method of the present invention also overcomes the drawbacks of the prior art in that it results in fully cured coatings.

The coating composition of the invention comprises:
(A) 100 parts by weight of an acryl functional organopolysiloxane consisting of the unit represented by the formula R¹Si0_{3/2}, the unit represented by the formula R¹R²ₐSiO_{(3-a)/2}, the unit represented by the formula R²_{b}R³_{c}SiO_{(4-b-c)/2}, and the unit represented by the formula R³_{d}SiO_{(4-d)/2}
   wherein:
   - R¹: is a group represented by 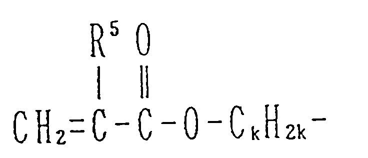 wherein R⁵ is a hydrogen atom or a methyl group, and k is an integer between 1 and 10;
   - R²: is a hydroxyl group;
   - R³: is a monovalent hydrocarbon group;
   - a and b: are 1 or 2;
   - c and d: are 0, 1, or 2;
   the molar ratio of R¹ with respect to the total number of moles of R¹, R², and R³ is 2-80 mole%; and
   the molar ratio of R² with respect to the total number of moles of R¹, R², and R³ is 3-90 mole%; and
(B) 0.01-25 parts by weight of a photopolymerization initiator. The method of the present invention comprises the steps of:
   (I) coating a surface of a substrate with the above-described composition;
   (II) irradiating the coated surface with ultraviolet radiation; and
   (III) heating the irradiated coating to a temperature between about 100°C and 300°C.

### DETAILED DESCRIPTION OF THE INVENTION

Component (A), the acryl functional organopolysiloxane used in the present invention, has an acryl group and a hydroxyl group simultaneously. It consists of the unit represented by the formula R¹SiO_{3/2}, the unit represented by the formula R²_{b}R³_{c}SiO_{(4-b-c)/2}, and the unit represented by the formula R³_{d}SiO_{(4-d)/2}
wherein R¹ is a group represented by 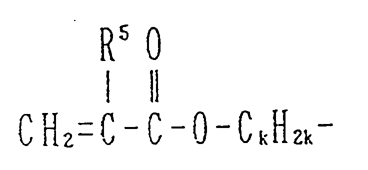 where R⁵ is a hydrogen atom or a methyl group, preferably a methyl group; K is an integer between 1 and 10, preferably 3; R² is a hydroxyl group; R³ is a monovalent hydrocarbon group exemplified by a methyl group, ethyl group, propyl group, or other alkyl groups, or a phenyl group, tolyl group, and other aryl groups. Among these, the phenyl group is preferred; a and b are 1 or 2, and c and d are numbers less than 2. Moreover, the ratio of R¹ with respect to the total number of moles of R¹, R², and R³ in this organopolysiloxane is 2-80 mole%, preferably 10-60 mole%. If this is less than 2 mole%, good curing characteristics cannot be obtained. The ratio of R² with respect to the total number of moles of R¹, R², and R³ is 3-90 mole%, preferably 10-70 mole%. If this is less than 3 mole%, good adhesion cannot be obtained.

The R¹SiO_{3/2} unit in the organopolysiloxane (A) has the effect of increasing the hardness of the cured material and to increasing its tenacity. The R¹R²ₐSiO_{(3-a)/2} unit has the effect of increasing the crosslinking density of the hardness of the cured material. Furthermore, the R³_{d}SiO_{(4-d)/2} unit can increase the hardness of the cured material. If R³ is a phenyl group, it has the effect of increasing the curing rate of the composition of the present invention.

The organopolysiloxane (A) as this can be easily manufactured by the dehydrochlorination condensation polymerization, for example, of methacryloxypropylthichlorosilane, acryloxypropyltrichlorosilane, and other acryloxyalkyltrichlorosilanes with diphenyldihydroxysilane, methylphenyldihydroxysilane, and other organosilanes in an organic solvent.

The photopolymerization initiator of component (B) promotes the polymerization reaction of the acryl functional organopolysiloxane of component (A) and functions in the acceleration of curing of the composition of the present invention. Suitable photopolymerization initiators include acetophenone, propiophenone, benzophenone, xanthone, benzaldehyde, 4-methylacetophenone, 3-pentylacetophenone, 4-methoxyacetophenone, 3-bromoacetophenone, 4-allylacetophenone, 3-methoxybenzophenone, p-chlorobenzophenone, 4-dimethoxybenzophenone, 4-chloro-4-benzylbenzophenone, 3-chloroxanthone, benzoin, benzoin methyl ether, benzoin-n-butyl ether, benzoin-iso-butyl ether, bis(4-dimethylaminophenyl) ketone, benzyl methoxy ketal, diethylacetophenone, 2,2-dimethoxy-2-phenylacetophenone and diethoxyacetophenone.

The amount of component (B) used in the composition of the invention, with respect to 100 parts by weight of the organopolysiloxane of component (A), is 0.01-25 parts by weight, preferably 0.1-10 parts by weight.

The composition of the present invention comprises component (A) and component (B) mentioned previously. However, in addition to components (A) and (B), an organoperoxide (C) is preferably added to further promote ultraviolet light-induced curing. Suitable organoperoxides include benzoyl peroxide, dimethyl benzoyl peroxide, chlorobenzoyl peroxide, dichlorobenzoyl peroxide, di-t-butyl peroxide, 2,5-di-t-butyl peroxybutyl-2,5-dimethylhexane, 2,5-di-t-butyl peroxybutyl-2,5-dimetylhexyl, t-butyl cumyl peroxide, dicumyl peroxide, t-butyl peroxybenzoate, t-butyl peroxy-4-chlorobenzoate, t-butyl peroxy-2, 4-dichloro benzoate, t-butyl peroxy-4-toluate, 1,1-di(t-butyl peroxy) cyclohexane, 1,1-di(t-butyl peroxy)-3,3,5-trimethylcyclohexane and 2,2-di(t-butyl peroxy)butane. Above all, a compatible di(tert-butyl) peroxide is preferred. The amount of organoperoxide (C) used with respect to 100 parts by weight of the organopolysiloxane of component (A) is 0.01-5 parts by weight.

The composition of the present invention can be easily manufactured by uniformly mixing components (A) and (B) and preferably component (C). In addition a solvent or a reactive diluent may also be added to improve the coatability on a substrate. Suitable solvents include toluene, xylene and butyl lactate. Suitable reactive diluent include monofunctional bifunctional and multifunctional acrylates.

In order to accelerate the curing reaction by ultraviolet-ray irradiation, a photosensitizer may also be added to the composition of the present invention. Suitable photosensitizers include 4-methyl-7-(N,N-dimethylamino) coumarin and other dyes, acetophenone, and other ketone-type or ether-type compounds, benzoquinone and other quinone-type compounds.

Furthermore, in order to improve the adhesion of the cured coating of the invention to a substrate, an adhesion promoter may also be added. Suitable adhesion promoters include gamma-(2-aminoethyl)aminopropyltrimethoxysilane and other alkoxysilanes.

The composition of the present invention may be used to coat the surface of electronic circuitry. Curing is then accomplished by exposure to ultraviolet radiation, overhead heating, or both. It is preferred that curing be carried out by exposure to ultraviolet radiation, followed by heating to a temperature between about 100°C and 300°C, and preferably between about 200°C and 250°C.

There are no special restrictions on the ultraviolet-ray irradiation apparatus used for curing the composition of the invention. Suitable equipment includes hydrogen electrical discharge tubes, high-pressure mercury lamps, intermediate-pressure mercury lamps, low-pressure mercury lamps, metal halide lamps, xenon lamps, chemical lamps and carbon arc lamps. There is also no special restriction with respect to the wavelength of the ultraviolet radiation used, however a wavelength of 250 to 400 nm is preferred. Irradiation of the coating composition may take place at room temperature or under cooling conditions and can be carried out under ambient atmosphere, vacuum conditions or an inert atmosphere.

For heating apparatus, a hot-air circulation-type oven, hot plate and infrared irradiating apparatus may be used.

The composition of the present invention cures rapidly when exposed to ultraviolet rays and heated and forms a film having high hardness. The hardened film exhibits excellent adhesion to organic resins of the type used in electronic circuitry. The composition of the invention may be used to protect such circuitry. The composition of the invention is suitable for protecting semiconductor elements, hybrid IC, printed circuit substrates, and liquid crystal display plates. It can also be used to form an insulating layer using photolithography in the manufacture of semiconductor devices and for printing.

### Application examples

The present invention is explained in detail, below, using application examples and a reference example. As used below, all "parts" are parts by weight.

### Reference Example 1

525 parts of gamma-methacryloxypropyl trichlorosilane, 3124 parts of toluene, and 0.047 part of p-methoxyphenol were placed in a 4-necked flask provided with a dripping funnel, a fractionation column, and a thermometer, and stirred. Next, a mixed solution of 329 parts of diphenyldihydroxysilane and 708 parts of triethylamine were slowly added dropwise to the reaction mixture. The resulting reaction mixture was stirred at 80°C for 2 h. Thereafter, a small amount of an aqueous hydrochloric acid solution was added to the mixture and allowed to react. The toluene layer was then separated from the aqueous layer. The reaction product recovered in the toluene layer was washed with water several times and heated under reduced pressure. A colorless, transparent, viscous liquid (439 g) was thus recovered. Analyses of this viscous liquid was carried out using ¹³C-nuclear magnetic resonance spectroscopy, ²⁹Si-NMR, and infrared spectroscopy, an organopolysiloxane represented by the empirical formula below was confirmed. Furthermore, as a result of analysis of this organopolysiloxane by gel permeation chromatography, its weight-average molecular weight calculated on the basis of polydimethylsiloxane was 1,700.

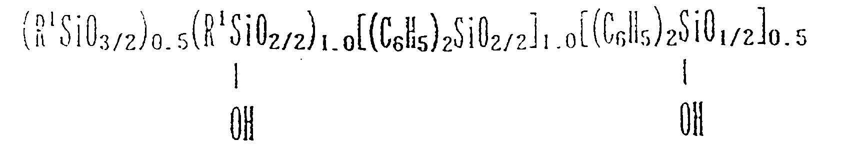

In the above formula, R¹ is a group represented by the following chemical structural formula.

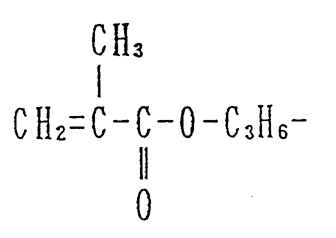

### Application Example 1

65 parts of the methacryloxyalkyl functional organopolysiloxane obtained in Reference Example 1, 5 parts of benzoin isobutyl ether, and 29 parts by weight of butyl lactate were uniformly mixed to prepare a composition in accordance with the invention. The composition was coated on a glass plate and dried to form a thin film. The dried film was subjected to ultraviolet light at an intensity of 100 mJ/cm² in a conveyor-type irradiating apparatus. Thereafter, the irradiated film was heated at 250°C for 1 h. The cured film had a 3H pencil hardness.

The same composition was also used to coat the surface of a semiconductor substrate, forming a dried film 20 micrometers thick. The film was cured as above and thereafter coated with a semiconductor-sealing epoxy resin (a bisphenol-type epoxy resin) to a thickness of 1 mm. The epoxy was cured by heating the sample to 180°C. The cured epoxy resin was then peeled from the semiconductor and the peeled surface examined. The cured composition of the invention was firmly adhered to the hardened epoxy resin. Peeling at the interface between the resin and cured composition of the invention could not be induced, even by scratching with a nail.

### Application Example 2

65 parts of the methacryloxyalkyl functional organopolysiloxane obtained in Reference Example 1, 5 parts of benzoin isobutyl ether, 29 parts of butyl lactate, and 1 part of di-(tert-butyl) peroxide were uniformly mixed to prepare a composition in accordance with the invention. This composition was coated on a glass plate and dried to form a thin film on the glass plate. Curing was carried out as described above in accordance with Application Example 1. The cured film had a 4H pencil hardness.

The same composition was examined for adhesion to cured epoxy resin in the manner previously described. Again, the peeled surface of the cured epoxy resin had the cured organopolysiloxane of the invention firmly adhered thereto. As in the previous application example, peeling could not be induced at the interface between the epoxy and the composition of the invention interface, even by scratching with a nail.

Although the composition of the present invention has been described utilizing examples thereof to point out various features and advantages, the scope of the invention is not so-limited and should be judged solely in accordance with the following claims and equivalents thereof.

## Claims

1. A radiation-curable Composition Comprising:
(A) 100 parts by weight of an acryl functional organopolysiloxane consisting of the unit represented by the formula R¹Si0_{3/2}, the unit represented by the formula R¹R²ₐSiO_{(3-a)/2}, the unit represented by the formula R²_{b}R³_{c}SiO_{(4-b-c)/2}, and the unit represented by the formula R³_{d}SiO_{(4-d)/2}
wherein:
R¹ is a group represented by 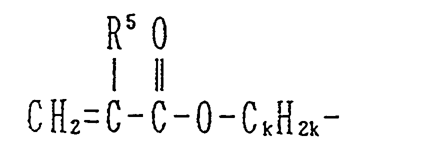 wherein R⁵ is a hydrogen atom or a methyl group, and k is an integer between 1 and 10;
R² is a hydroxyl group;
R³ is a monovalent hydrocarbon group;
a and b are 1 or 2;
c and d are 0, 1, or 2;
the molar ratio of R¹ with respect to the total number of moles of R¹, R², and R³ is 2-80 mole%; and
the molar ratio of R² with respect to the total number of moles of R¹, R², and R³ is 3-90 mole%; and
(B) 0.01-25 parts by weight of a photopolymerization initiator.

2. A composition in accordance with Claim 1 further comprising (C) 0.01-5 parts, by weight, of an organoperoxide.

3. A composition in accordance with Claim 1 where said R³ is a phenyl group.

4. An article of manufacture comprising:
a substrate presenting at least one surface;
said at least one surface having a coating thereon; and
said coating being formed from the radiation-cured composition of Claim 1.

5. A method of forming a cured coating on a surface of a substrate, said method comprising the steps of:
(I) coating said surface with the composition of Claim 1;
(II) irradiating said coated surface with ultraviolet radiation; and
(III) heating said irradiated coating to a temperature between about 100°C and 300°C.

6. A method in accordance with Claim 5 wherein said heating step (III) is carried out at a temperature between about 200°C and 250°C.

7. A method of forming a cured coating on a surface of a substrate, said method comprising the steps of:
(I) coating said surface with the composition of Claim 2;
(II) irradiating said coated surface with ultraviolet radiation; and
(III) heating said irradiated coating to a temperature between about 100°C and 300°C.

8. A method in accordance with Claim 7 wherein said heating step (III) is carried out at a temperature between about 200°C and 250°C.
